# EUROPEAN PATENT APPLICATION

(11) **EP 0 684 633 A2**
(43) Date of publication of application: **29.11.1995**
(21) Application number: 95105463.4
(22) Date of filing: 11.04.1995
(51) Int. Cl.: H01L 21/285, H01L 29/10, H01L 21/338, H01L 21/335

(54) **Method for manufacturing a semiconductor device**

(30) Priority: 26.05.1994 JP 112837/94
(71) Applicant: FUJITSU LIMITED, Kawasaki-shi, Kanagawa 211 (JP)
(72) Inventor: Yokoyama, Teruo, c/o Fujitsu Limited, Kawasaki-shi, Kanagawa, 211 (JP); Moriuchi, Toshiaki, c/o Fujitsu Limited, Kawasaki-shi, Kanagawa, 211 (JP)
(74) Representative: Seeger, Wolfgang, Dipl.-Phys.

(57) **Abstract**

An insulating layer (19) is formed on a semiconductor layer (14,15,16,34 or 43) containing an impurity. The semiconductor layer (14,15,16,34 or 43) coated with the insulating layer (19) is heated at a first temperature in order to recover damage of the semiconductor layer due to the formation of the insulating layer (19). A first opening (22) is then formed through the insulating layer (19), followed by forming a conductive layer (23) capable of making schottky contact with the semiconductor layer (14,15,16,34 or 43) in the first opening (22) and on the insulating layer (19). The semiconductor layer (14,15,16,34 or 43) is then heated at a second temperature lower than the first temperature in order to remove lattice defects occurring between the conductive layer (23) and the semiconductor layer (14,15,16,34 or 43).

## Description

### BACKGROUND OF THE INVENTION

### 1. Field of the invention

The present invention relates to a method for manufacturing semiconductor devices. In particular, it relates to a method for manufacturing semiconductor devices provided with an electrode making schottky contact with a semiconductor layer.

### 2. Description of the prior art.

There have been broadly utilized a variety of semiconductor devices formed from compound semiconductors suitable for use in applications requiring high speed operation and/or high frequency operation. The semiconductor devices of this kind include a MESFET(Metal-Semiconductor FET), a HEMT(High Electron Mobility Transistor) and the like.

Next, a manufacturing process for forming a MESFET will be briefly explained.

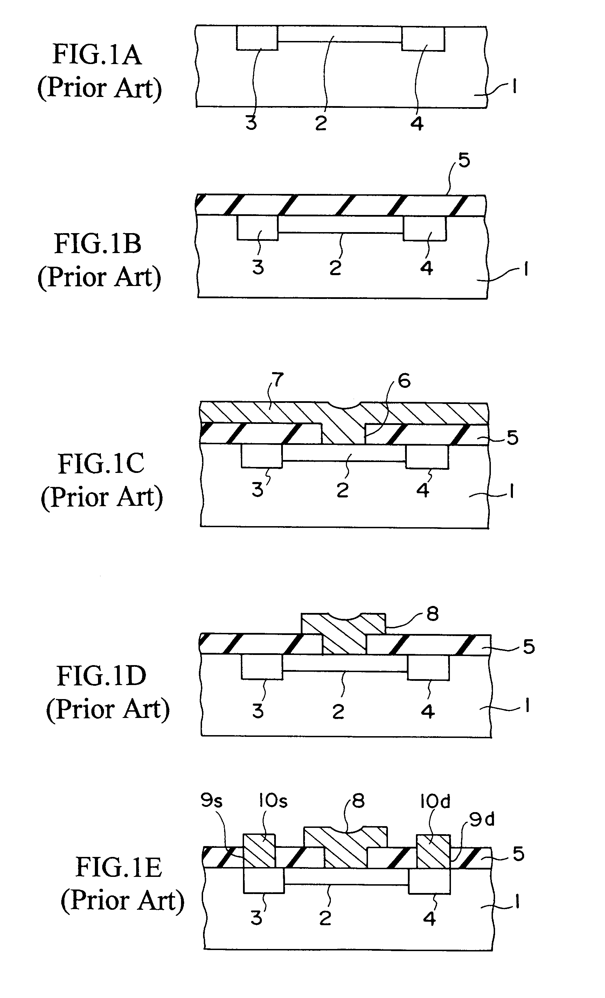

First, as illustrated in Fig.1A, silicon is introduced into an active region of a GaAs substrate 1 by ion implantation and activated in order to form an n-GaAs layer 2, followed by formation of n⁺⁻ GaAs layers 3 and 4 on both sides of the GaAs layer 2 by the same manner.

An insulating layer 5 consisting of a silicon oxide film, a silicon nitride film or the like is then formed on the GaAs substrate 1 by plasma CVD as illustrated in Fig.1 B.

The insulating layer 5 is then patterned by photolithography in order to form an opening 6 in a location just over the n-GaAs layer 2, followed by formation of a tungsten silicide layer (WSi layer) 7 on the insulating layer 5 and in the opening 6 by sputtering as illustrated in Fig.1 C. The WSi layer 7 is formed to make schottky contact with the n-GaAs layer 2.

Next, the GaAs substrate 1 is heated in order to recover the crystallinity of the surface portion of the GaAs substrate 1,which has been damaged by the previous plasma CVD. The temperature of the thermal treatment is about 600 _{°} C.

The WSi layer 7 is patterned by photolithography after the thermal treatment in order to leave it only the area in the opening 6 and the periphery thereof as illustrated in Fig.1 D, thus forming a gate electrode 8 of a T shape.

Furthermore, as illustrated in Fig.1 E, after the insulating layer 5 is patterned to form openings 9s and 9d in locations just over the n⁺⁻GaAs layers 3 and 4, a source electrode 10s and a drain electrode 10d are formed to make ohmic contact with the n⁺⁻GaAs layers 3 and 4 through the openings 9s and 9d.

This formation process of a MESFET is described, for example, in Microwave Syst. News 13 (7), 1983.

However, when thermal treatment is given for the purpose of recovering the crystallinity of the surface portion of the GaAs (semiconductor) substrate 1 on which the insulating layer 5 covered by the WSi 7 is formed thereon as described above, there tends to occur variation of threshold voltage between different transistors formed within the same semiconductor substrate and between transistors of different batches. Such variation of threshold voltage results in decreasing yield.

The variation of threshold voltage originates from the thermal treatment given at 600 °C to the GaAs substrate 1 in which the n-GaAs layer 2 makes schottky contact with the WSi layer 7 formed on the insulating layer 5 through the opening 6. This problem may arise also in the case of manufacturing an HEMT.

The variation of threshold voltage of transistors may be avoided by lowering the temperature of the thermal treatment. However, the crystallinity of the semiconductor layer making schottky contact with the gate electrode can not be sufficiently recovered at a low temperature so that a reverse breakdown voltage to the gate electrode is decreased and therefore breakdown may frequently occur.

### SUMMARY OF THE INVENTION

The present invention has been made in order to solve the shortcomings as described above.

It is an object of the present invention to provide a method for manufacturing semiconductor devices with decreased variation of the threshold voltage of transistors having a "T"-shaped gate electrode and with an increased breakdown to the gate electrode of the transistors.

First, in accordance with the method for the present invention, an insulating layer is formed on a semiconductor layer containing an impurity. In this case, the semiconductor layer is damaged during formation of the insulating layer to degrade the crystallinity thereof. The crystallinity of the semiconductor layer is therefore recovered after the formation of the insulating layer by heating it at a first temperature. Next, a first opening is formed through the insulating layer. A conductive layer capable of making schottky contact with the semiconductor layer is formed within the first opening. The semiconductor layer is then heated at a second temperature lower than the first temperature in order to recover the damage due to formation of the conductive layer.

The first temperature is higher than 550 °C while the second temperature is no lower than 400 °C and no higher than 550 °C. The semiconductor layer is made from an n-type GaAs, or any other compound semiconductors. The insulating layer is a single-layered structure made from either of silicon oxide and silicon nitride or a dual-layered structure made from a silicon nitride layer and a silicon oxide layer.

In accordance with the present invention as described above, a semiconductor layer is heated by a first thermal treatment after an insulating layer is formed on the semiconductor layer, and heated by a second thermal treatment after formation of a conductive layer in an opening formed through the insulating layer. The crystallinity of the semiconductor layer is recovered by these two thermal treatments.

The damage imparted to the semiconductor layer during formation of the insulating layer is recovered by the first thermal treatment. The damage imparted to the semiconductor layer during formation of the conductive layer and the opening is recovered by the second thermal treatment. The temperature of the first treatment is set higher than that of the second thermal treatment. For example, the temperature of the first thermal treatment is higher than 550 °C while the temperature of the second thermal treatment is no lower than 400 °C and no higher than 550 _{°} C.

The damage imparted to the semiconductor layer during formation of the insulating layer is removed by recrystallization caused by the relatively high temperature during the first thermal treatment. The damage of the surface portion of the semiconductor layer is removed by the high temperature thermal treatment so as to increase the breakdown voltage as compared with those of conventional "T"-shaped gate devices.

The temperature of the second thermal treatment is selected to be relatively low in order to decrease the stress due to heat applied to the conductive layer and the insulating layer. If the stress strongly appears, the threshold voltage of semiconductor devices becomes substantially dispersed. Accordingly, equality of the threshold voltage is maintained by lowering the temperature of the second thermal treatment.

When the recovery of crystallinity near the surface of the semiconductor layer is not sufficient, the surface portion of the semiconductor layer is removed by etching. Also, in order to decrease lattice defects just below the opening, it is effective to utilize wet etching for forming the opening.

The introduction of an impurity into the semiconductor layer can be performed at the same time as the formation of the semiconductor layer or after the formation of the semiconductor layer by ion implantation.

The method for manufacturing semiconductor devices in accordance with the present invention is applicable for MESFETs or HEMTs having "T"- shaped gate electrodes.

### BRIEF DESCRIPTION OF THE DRAWINGS

Figs.1A through 1E are cross sectional views showing a method for manufacturing a MESFET in accordance with a conventional technique;
Figs.2A through 2D are cross sectional views showing a method for manufacturing a MESFET in accordance with a first embodiment of the present invention;
Figs.3A through 3D are cross sectional views showing the method for manufacturing a MESFET in accordance with the first embodiment of the present invention subsequent to the steps illustrated in Figs.2A through 2D;
Figs.4A through 4D are cross sectional views showing the method for manufacturing a MESFET in accordance with the first embodiment of the present invention subsequent to the steps illustrated in Figs.3A through 3D;
Fig.5 is a graphical diagram showing the relationship between the temperature of thermal treatment during a manufacturing process for semiconductor devices and the reverse breakdown voltage to the gate electrodes of the semiconductor devices;
Fig.6 is a graphical diagram showing the relationship between the temperature of thermal treatment during a manufacturing process for semiconductor devices and the standard deviation ₆ᵥₜₕ of the threshold voltage of the semiconductor devices;
Fig.7 is a graphical diagram showing the relationship between the temperature of thermal treatment during a manufacturing process for semiconductor devices and the drain saturation current of the semiconductor devices;
Fig.8 is a cross sectional view showing a MESFET formed by a method in accordance with a second embodiment of the present invention; and
Fig.9 is a cross sectional view showing an HEMT formed by a method in accordance with a third embodiment of the present invention.

### DETAILED DESCRIPTION OF THE PREFERRED EMBODIMENTS

Next, methods for forming semiconductor devices in accordance with embodiments of the present invention will be described with reference to the accompanied drawings.

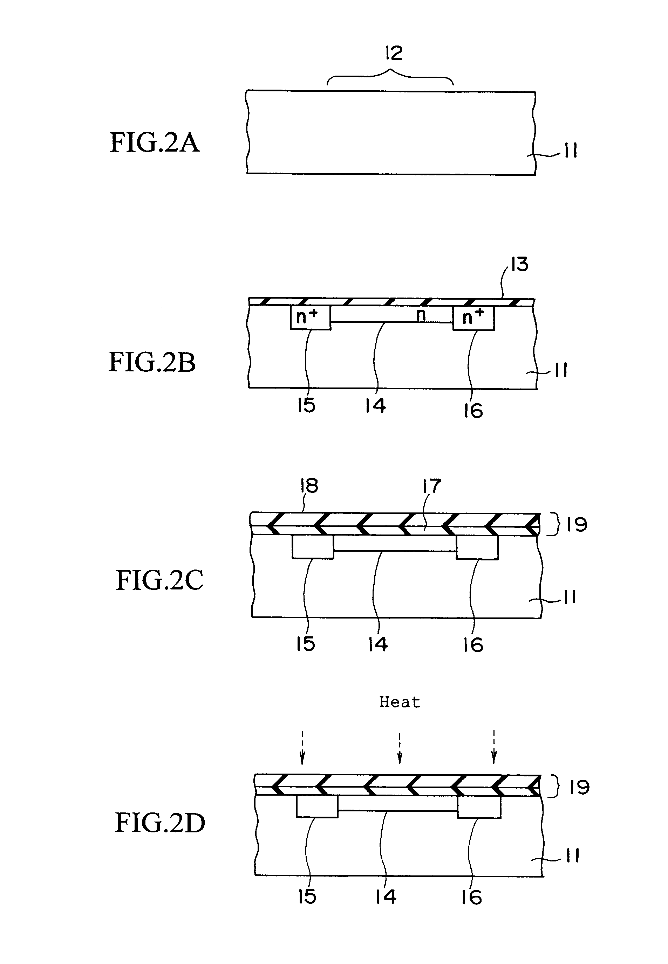

Figs.2 through 4 are cross sectional views showing the method for forming a MESFET in accordance with a first embodiment of the present invention.

First, as illustrated in Fig.2A, silicon is introduced into an active region 12 of a semi-insulating gallium arsenic (GaAs) substrate 11 by ion implantation. The ion implantation is carried out in two steps. The first step is performed in the entirety of the active region 12 with an acceleration energy of 60 keV and a dose amount of 4x 10'²/cm². The second step is performed in the both sides of the active region 12 with an acceleration energy of 120 keV and a dose amount of 2x 10¹³/cm₂.

The surface of the GaAs substrate 11 is then coated with a silicon oxide (Si0₂) film 13 by CVD followed by giving thermal treatment at about 800 °C in order to activate the silicon introduced into the GaAs substrate 11. By this process, there are formed an n-GaAs region 14 serving as a channel region and n⁺⁻ GaAs regions 15 and 16 serving as contact regions (source and drain regions).

Meanwhile, the activation of the silicon may be carried out after formation of an insulating layer 19 (described supra) depending upon the actual case in practice. The temperature of the thermal treatment is no lower than 800 _{°} C in this case.

Next, after removal of the Si0₂ film 13, a silicon nitride (SiN) layer 17 and a silicon oxide (Si0₂) layer 18 are formed on the GaAs substrate 11 respectively to a thickness of 100nm and a thickness of 200nm by plasma CVD to form an insulating layer 19 as illustrated in Fig.2C. The SiN layer 17 is grown with a growth gas of SiH₄ and N₂ at a growth temperature of 300 _{°} C in a pressure of about 1 Torr. The Si0₂ layer 18 is grown with a growth gas of SiH₄ and 0₂ at a growth temperature of 300 _{°} C in a pressure of 1 Torr.

The SiN layer 17 is particularly suitable for forming a passivation film while the Si0₂ layer 18 is more appropriate than the SiN layer 17 in term of causing weaker stress. However, the insulating layer 19 is not limited to such a dual layered structure but also can be formed only of either one of the SiN layer 17 and the Si0₂ layer 18 or formed of another film such as a silicon nitride oxide (SiON) film.

Next, after formation of the insulating layer 19, the GaAs substrate 11 is heated at a temperature of higher than 550 °C for about 30 minutes as illustrated in Fig.2D. Thus, the crystallinity of the surface of the GaAs substrate 11 is recovered from the substantial damage received due to plasma CVD.

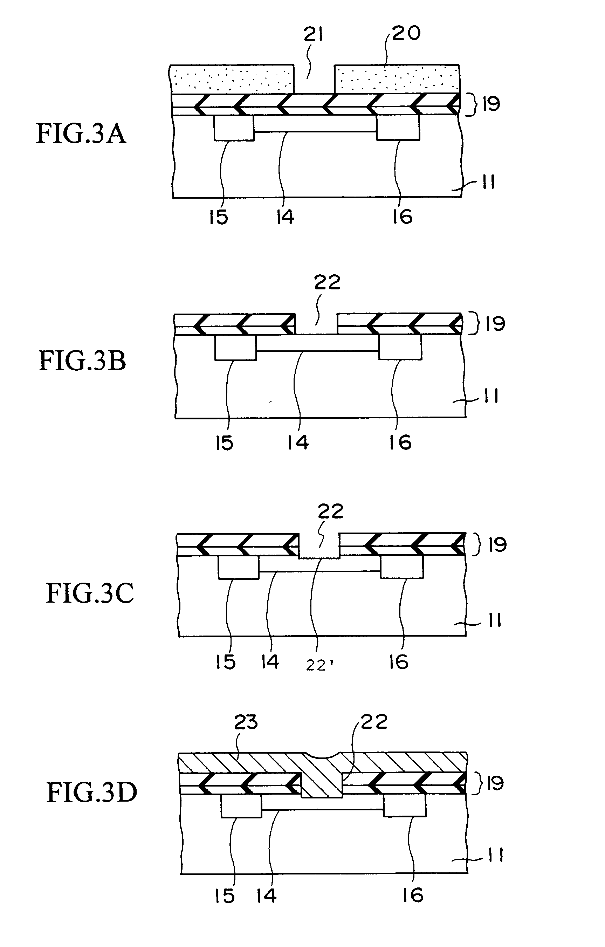

After the thermal process, a resist film 20 is coated on the GaAs substrate 11 and then patterned to from an opening 21 through exposure and development, as illustrated in Fig.3A, in a location where a gate electrode is to be formed.

The portion of the insulating layer 19 exposed through the opening 21 is then removed by reactive ion etching (RIE) in order to form an opening 22 through the insulating layer 19 above the n-GaAs region 14. In this case, CHF₃ is used as an etchant gas. Fig.3B illustrates the structure in which the resist 20 is removed after formation of the opening 22. Another type of dry etching can be used in this process instead of RIE.

Next, as illustrated in Fig.3C, the surface portion of the n-GaAs region 14 is subjected to wet etching to form a recess 22' to a depth of 10 to 20 nm. A recess structure is thus formed on the n-GaAs region 14. The etchant solution utilized in this process is, for example, a solution containing hydrofluoric acid and hydrogen peroxide.

Next, after formation of the recess structure, a tungsten silicide layer 23 is formed on the insulating layer 19 and in the opening 22 as illustrated in Fig.3D.

As illustrated in Fig. 4A, the GaAs substrate 11 is then heated at 400 to 550 °C for about 30 minutes in order to recover the crystallinity of the GaAs substrate 11 in which lattice defects have occurred during formation of the opening 22 and the WSi layer 23. In order to minimize the formation of lattice defects, it is preferred to form the opening 22 by wet etching.

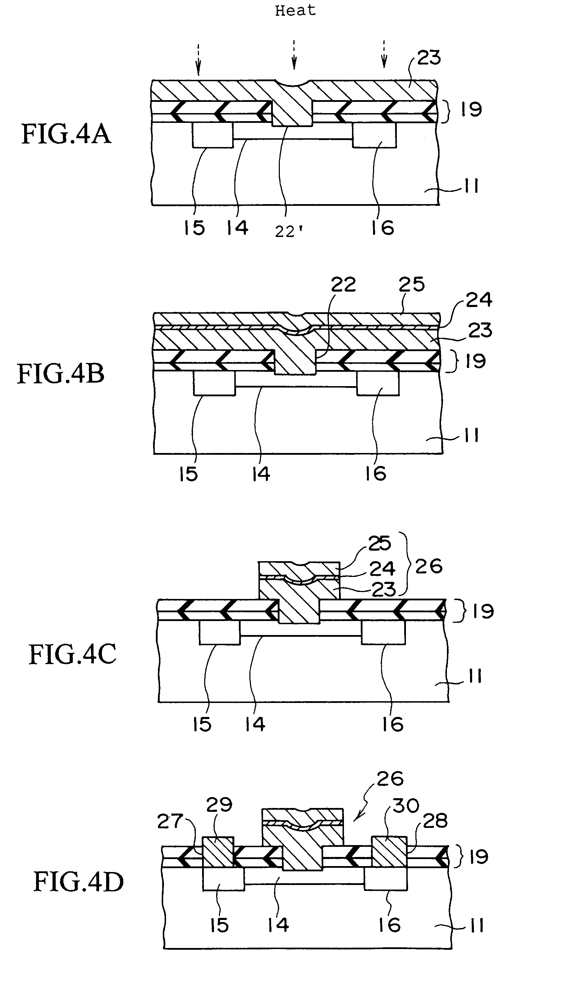

Next, as illustrated in Fig.4B, a titanium (Ti) layer 24 and a gold (Au) layer 25 are deposited on the WSi layer 23 by sputtering in this order, followed by patterning the Ti layer 24, the Au layer 25 and the WSi layer 23 to leave the three layers only in the periphery of the opening 22 and the inside of the opening 22. A "T"-shaped gate electrode 26 in schottky contact with the n-GaAs region 14 through the opening 22 is formed by this process, as illustrated in Fig. 4C.

Next, as illustrated in Fig.4D, the insulating layer 19 is patterned to form openings 27 and 28 to expose the n⁺⁻ GaAs regions 15 and 16. The upper surface of the structure is covered by a resist film (not shown in the figure) except for the exposed surfaces of the n⁺⁻ GaAs regions 15 and 16. The entire surface of the structure is then coated with a triple-layered conductive film (not shown in the figure) consisting of a gold-germanium (AuGe) film, an nickel (Ni) film and gold (Au) film disposed in this order. The resist film is then removed to pattern the triple-layered conductive film by the lift-off technique. By this process, as illustrated in Fig.4D, a source and a drain electrodes 29 and 30 are formed making contact with the n⁺⁻ GaAs regions 15 and 16 respectively through the openings 27 and 28. The MESFET is then substantially completed.

After this, necessary interconnections are formed to make electrical connection between the MESFET and other peripheral circuits formed on the same semiconductor substrate.

Meanwhile, the n-GaAs region 14 and the n⁺⁻ GaAs regions 15 and 16 can be formed within a GaAs layer epitaxially grown on the GaAs substrate 11.

As described above, thermal treatment is performed in two steps at different temperatures before and after the formation of the WSi layer 23 serving as a gate electrode 26 in the manufacturing process of the MESFET. Namely, the GaAs substrate 11 is heated, for example, at 650 °C before the formation of the WSi layer 23 on the GaAs substrate 11 and at 500 °C after the formation of the WSi layer 23 on the GaAs substrate 11. In accordance with experiments, there were observed several advantages associated with the recovery of the crystallinity of the semiconductor layer by the thermal treatment in two steps at different temperatures. Namely, the variation of threshold voltage of transistors was limited and the withstand voltage (breakdown voltage) between the gate electrode and the drain electrode is improved. These advantages could be obtained according to the following mechanism.

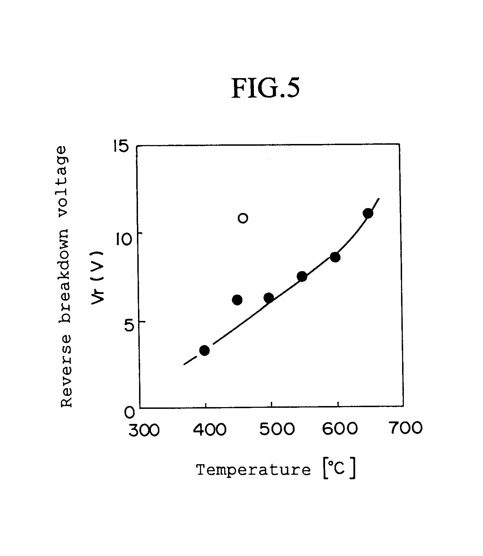

The inventors of the present invention conducted an comparative experiment in which thermal treatment was performed only after the formation of the WSi layer 23 for recovery of the crystallinity of the semiconductor layer of the GaAs substrate 11 in the manufacture process as illustrated in Figs.lA to 1E. The variation of threshold voltage of transistors and the reverse breakdown voltage Vr applied on the gate electrode were measured while the temperature of the thermal treatment is varied. Figs.5 to 7 are graphical diagrams in which the measurement results are plotted.

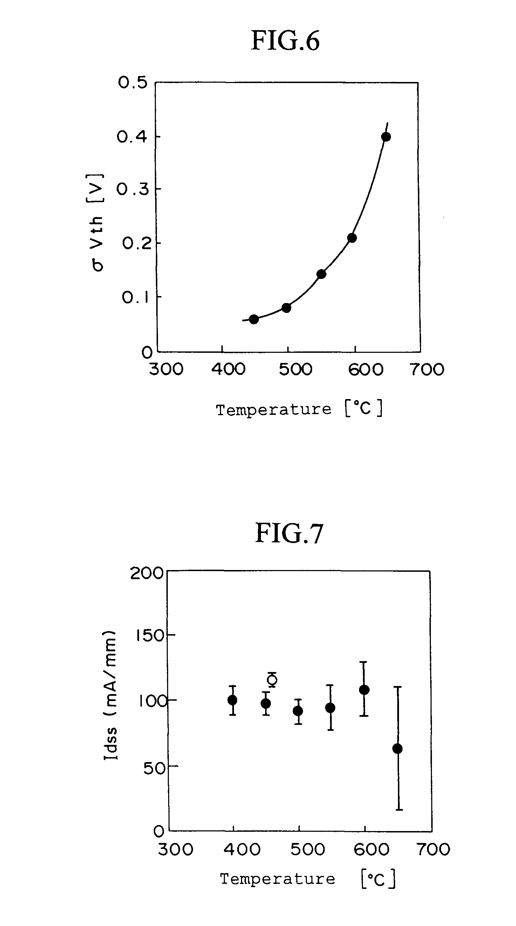

As illustrated in Fig.5, the breakdown voltage Vr to the gate electrode was increased as the temperature of thermal treatment was elevated. Also, as illustrated in Fig.6, the variation of threshold voltage of transistors was widened as the temperature of thermal treatment was elevated. Furthermore, as illustrated in Fig.7, variation of the drain saturation current I_{dss}, which has been measured by setting the gate voltage to be 0 and the drain voltage to be 3V, was increased as the temperature of thermal treatment was elevated. The abscissa of the diagram in Fig.6 represents the standard deviation ₆ᵥₜₕ of the threshold voltage while the vertical line passing through solid circles in the direction of the abscissa of the diagram in Fig.7 represent the respective standard deviations of the drain saturation current.

Breakdown due to the reverse voltage applied to the gate electrode easily occurs near lattice defects. For example, in the case of the MESFET having a "T"-shaped gate electrode as illustrated in Fig.4D, lattice defects caused during formation of the insulating layer 19 on the surface of the GaAs substrate 11 tend to form a current path, resulting in breakdown. Namely, the lattice defects on the surface of the GaAs substrate 11 often become the cause of breakdown. Accordingly, when the gate voltage is 7V, recrystallization of the surface portion of the GaAs substrate 11 can not be dispensed with, as will be understood from Fig.5. Also, when it is needed to prevent the impurity (silicon) contained in the n-GaAs region 14 from rediffusion, the temperature for the recrystallization is preferably no higher than, e.g., 900 _{°} C.

Meanwhile, when thermal treatment is performed with the WSi layer 23 formed on the insulating layer 19, thermal contraction and thermal stretch are generated in the WSi layer 23 and the insulating layer 19. Accordingly, the stress occurring in the gate electrode 26 and the insulating layer 19 adjacent thereto extends to the underlying GaAs substrate 11. The stress applied to the GaAs substrate 11 in this manner generates electric carriers by the piezo effect within the n-GaAs region 14. The strength of the stress tends to be dispersed from lot to lot and from location to location in the same substrate, resulting in variation of the threshold voltage between transistors formed in the same substrate and between different lots.

In order to suppress the variation of the threshold voltage, the recrystallization temperature must be lowered as will be understood from Figs.6 and 7. When it is desired to limit the standard deviation σ_{Vth} below 0.2V and the drain saturation current I_{dss} below 100mA/mm, the thermal treatment must be carried out at a temperature no higher than 550 _{°} C as will be understood from Figs.6 and 7. Since it is difficult to perform recrystallization at a temperature no higher than 400 °C in practice, the thermal treatment is carried out at a temperature no lower than 400 _{°} C and no higher than 550 _{°} C to perform recrystallization.

Taking in mind the above described experimental fact, it will be understood that thermal treatment at a temperature no lower than 550 _{°} C can be performed before the formation of the WSi layer 23 serving as a gate electrode 26 in order to avoid the generation of lattice defects in the surface portion of the GaAs substrate 11 and minimize the thermal stress applied to the gate electrode 26 and the insulating layer 19.

Also, when the GaAs substrate 11 is recrystallized to remove lattice defects caused during formation of the opening 22 of the insulating layer 19 or formation of the WSi layer 23, thermal treatment is given to the GaAs substrate 11 after the formation of the WSi layer 23 at a temperature no lower than 400 _{°} C and no higher than 550 _{°} C to perform recrystallization of the GaAs substrate 11. The crystallinity of the GaAs substrate 11 is usually sufficient by thermal treatment at the temperature no lower than 400 °C and no higher than 550 °C. However, if the recovery of crystallinity near the surface of the GaAs substrate 11 is not sufficient, the surface portion of the GaAs substrate 11 is removed as described above.

Examples of experiments of the thermal treatment in two steps as described above for improving the crystallinity of the semiconductor substrate will be explained in the followings. First, as illustrated in Fig.2D, the crystallinity of the GaAs substrate 11 is improved by thermal treatment at 650 °C after formation of the insulating layer 19. The reverse breakdown voltage Vr to the gate electrode could be expected to be about 11 V by the thermal treatment at 650 °C as illustrated in Fig. 5. The crystallinity of the GaAs substrate 11 is improved again by thermal treatment at 460 °C after formation of the WSi layer 23 on the insulating layer 19. Since the thermal treatment was performed at 460 ° C, the drain saturation current I_{dss} was about 11 OmA/mm only with a limited standard deviation as illustrated in Fig.7 with an open circle. When the reverse breakdown voltage was measured after thermal treatment at 460 °C, the result of measurement was about 11 V in agreement with that expected from the open circle in Fig.5.

It will be understood from the experiments that in accordance with the present invention the variation of the threshold voltage is substantially limited as compared with that of MESFETs in accordance with the conventional technique and that the reverse breakdown voltage Vr to the gate electrode can be increased.

As apparent from Figs.5, 6 and 7, when it is desired to limit the reverse breakdown voltage no lower than 10V and the variation of the threshold voltage within 100mV or narrower, thermal treatment can be performed at a temperature no lower than 620 _{°} C before the formation of the WSi layer 23 and at a temperature no lower than 400 °C to 550 _{°} C after the formation of the WSi layer 23 to meet the requirements.

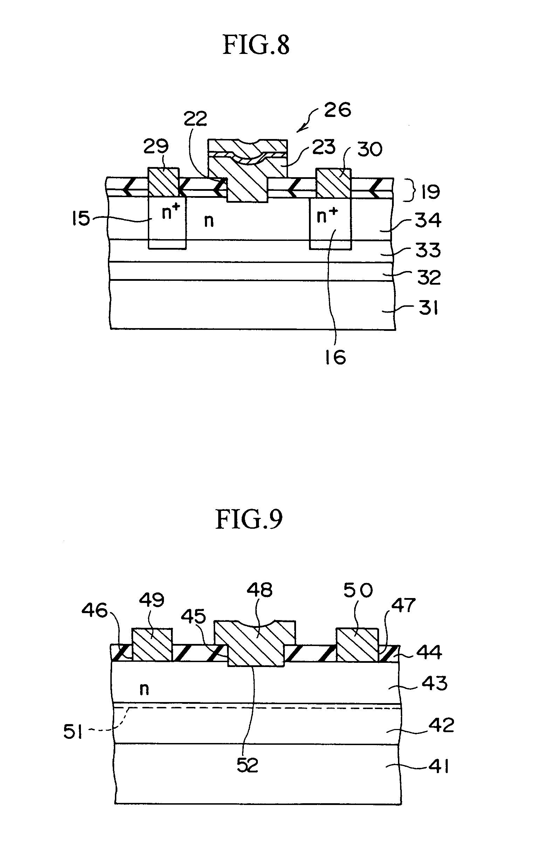

The description of the above embodiment has been made to the MESFET provided with the n-GaAs region 14 serving as a channel region is formed by ion implantation. However, other types of MESFETs can be manufactured by the similar process including thermal treatment performed in two steps at different temperatures before and after the formation of the WSi layer 23 serving as a gate electrode 26 in the manufacturing process of the MESFET. Fig.8 illustrates one example of such a MESFET provided with an n-GaAs layer 34 epitaxially grown on a semi-insulating GaAs substrate 31 through an n-GaAs layer 32 and an AIGaAs buffer layer 33. The reverse breakdown voltage Vr and the variation of the threshold voltage can be improved also in this case. Meanwhile, the same numerals are given to similar elements also in Fig.8 as compared with Figs.2 to 4.

In the same manner, the thermal treatment performed in two steps at different temperatures before and after the formation of the conductive layer serving as a gate electrode can be applied for the manufacturing process of the HEMT having a "T"-shaped gate electrode as illustrated in Fig.9. The reverse breakdown voltage and the variation of the threshold voltage can be improved also in this case.

In Fig.9, a un-doped GaAs layer 42, an n-AIGaAs layer 43 and an insulating layer 44 are formed on a semi-insulating GaAs substrate 41 in this order. First to third openings 45 to 47 are formed through the insulating layer 44. A "T"- shaped gate electrode 48 is formed in the first opening 45, making schottky contact with the n-AIGaAs layer 43. Also, a source electrode 49 and a drain electrode 50 are formed, making ohmic contact with the n-AIGaAs layer 43 respectively through the second opening 46 and the third opening 47. Two dimensional electron gas exists near the junction between the un-doped GaAs layer 42 and the n-AIGaAs layer 43. Also, a recess 52 is formed in the n-AIGaAs layer 43 just below the gate electrode 48.

The description of the above embodiments have been made to the MESFET provided with the gate electrode made from WSi. However, the gate electrode can be made from aluminum, tungsten titanium and so forth instead. Also, the description of the above embodiments have been made to the MESFET provided with the semiconductor layer serving as a channel region made from GaAs. However, other semiconductors such as an InGaAs can be utilized for the same purpose. Furthermore, in the HEMT as described above, a un-doped InGaAs layer can be used in place of the un-doped GaAs layer while an InGaP layer, an InGaAs layer and the like doped with an n-type impurity can be utilized in place of the n-AIGaAs layer. N-type impurities available for forming n-type compound semiconductors include, for example, selenium and tin besides silicon as employed in the above.

## Claims

1. A method for manufacturing a semiconductor device comprising:
a) forming an insulating layer (19) on a semiconductor layer (14,15,16) containing an impurity;
b) heating said semiconductor layer (14,15,16) coated with said insulating layer (19) at a first temperature;
c) forming a first opening (22) through said insulating layer (19);
d) forming a conductive layer (23) capable of making schottky contact with said semiconductor layer in (14,15,16) said first opening (22); and
e) heating said semiconductor layer (14,15,16) at a second temperature lower than said first temperature.

2. The method for manufacturing a semiconductor device as claimed in claim 1 wherein said semiconductor layer (14,15,16) is formed from an n-type compound semiconductor such as GaAs, InGaAs, and InGaP and said conductive layer (23) is formed from WSi, Al, WTi,TiW, and TiWN.

3. The method for manufacturing a semiconductor device as claimed in claim 1 wherein said first temperature in said step b) is a temperature at which said semiconductor layer is recrystallized.

4. The method for manufacturing a semiconductor device as claimed in claim 1 wherein said first temperature in said step b) is higher than 550 °C and the second temperature in said step e) is no lower than 400 _{°} C and no higher than 550 _{°} C.

5. The method for manufacturing a semiconductor device as claimed in claim 1 wherein said steps a) to e) are carried out in this order.

6. The method for manufacturing a semiconductor device as claimed in claim 1 wherein said insulating layer (19) is a single-layered structure made from either of silicon oxide and silicon nitride or a dual-layered structure made from a silicon nitride layer and a silicon oxide layer.

7. The method for manufacturing a semiconductor device as claimed in claim 1 further comprising a step f) of etching a portion of said semiconductor layer (14) just below said first opening (22) before formation of said first opening (22) in said step d) and after formation of said conductive layer (23) in said step e).

8. The method for manufacturing a semiconductor device as claimed in claim 1 wherein said impurity contained in said semiconductor layer (14,15,16) is introduced by ion implantation.

9. The method for manufacturing a semiconductor device as claimed in claim 1 wherein in said step c) said first opening (22) is formed by photolithography using wet etching.

10. The method for manufacturing a semiconductor device as claimed in claim 1 further comprising:
g) forming a gate electrode (26) through said first opening (22) by patterning said conductive layer (23);
h) forming second and third openings (27,28) through said insulating layer (19) in opposite sides of and apart from said first opening (22); and
i) forming two electrodes (29,30) making ohmic contact with said semiconductor layer through said second and third openings (27,28).

11. The method for manufacturing a semiconductor device as claimed in claim 9 wherein said semiconductor layer (14) just under said gate electrode (26) serves as a channel region of a field effect transistor.

12. The method for manufacturing a semiconductor device as claimed in claim 9 wherein said semiconductor layer (43) contains an impurity, wherein a un-doped second semiconductor layer (42) is formed below said semiconductor layer (43), and wherein a two-dimensional electron gas (51) exists at a junction between said semiconductor layer (43) and said second semiconductor layer (42).
